# EUROPÄISCHE PATENTSCHRIFT

(11) **EP 1 775 650 B1**
(45) Veröffentlichungstag und Bekanntmachung des Hinweises auf die Patenterteilung: **11.07.2012**
(21) Anmeldenummer: 06020796.6
(22) Anmeldetag: 04.10.2006
(51) Int. Cl.: G05G 1/02, G05G 1/10

(54) **Bedienvorrichtung für ein Elektrogerät**
Operating device for an electric appliance
Dispositif de commande pour appareil électrique

(30) Priorität: 12.10.2005 DE 102005049995; 14.12.2005 DE 202005019978 U
(43) Veröffentlichungstag der Anmeldung: 18.04.2007
(73) Patentinhaber: E.G.O. ELEKTRO-GERÄTEBAU GmbH, 75038 Oberderdingen (DE)
(72) Erfinder: Baier, Martin, 76275 Ettlingen (DE)
(74) Vertreter: Patentanwälte Ruff, Wilhelm, Beier, Dauster & Partner

(56) Entgegenhaltungen:
- EP-A1- 0 282 817
- EP-A1- 0 725 181
- WO-A-2005/066547
- DE-A1- 1 497 249
- DE-A1- 3 642 807
- GB-A- 2 361 292
- US-A- 4 408 172
- US-A1- 2003 178 291

## Beschreibung

### Anwendungsgebiet und Stand der Technik

Die Erfindung betrifft ein Elektrogerät mit einer Bedienvorrichtung mit einer Bedieneinheit, die einen Dreh- oder Schieberegler umfasst, wobei die Bedieneinheit an oder auf einer Blende bzw. Auflagefläche des Elektrogeräts gehaltert ist. Dies erfolgt insbesondere drehbeweglich oder schiebebeweglich. Des Weiteren betrifft die Erfindung ein Bedienverfahren zur Bedienung eines Elektrogerätes.

Aus der DE 19833983 A1 ist allgemein ein Drehregler als Energieregler bzw. Bedienvorrichtung für ein Elektrogerät bekannt, beispielsweise für ein Kochfeld.

Die DE 29605163 U1 schlägt zur Übertragung der Drehstellung einer als Drehregler ausgebildeten Bedieneinheit vor, den Drehregler mit einem Lichtwellenleiter auszubilden. Dieser strahlt Licht, welches im Bereich der Drehachse des Drehreglers von unten in den Drehregler eingekoppelt wird, je nach Drehstellung an verschiedener Position nach unten ab. Unter einer Auflagefläche sind zu diesem Zweck im Bereich der Drehachse des Drehreglers eine Lichtquelle angeordnet und ringförmig um diese herum lichtempfindliche Sensoren. Diese registrieren je nach Drehstellung des Drehreglers an verschiedener Position das durch den Lichtwellenleiter hindurch geleitete und an der Unterseite der Bedieneinheit abgestrahlte Licht. Die DE 10212954 A1 beschreibt die Verwendung einer Bedieneinheit mit Mikroprozessor, der die Drehstellung eines Drehknebels der Bedieneinheit relativ zu einer winkelstabilen Lagervorrichtung, auf der der Drehknebel gelagert ist, registriert und an einen unter der Auflagefläche angeordneten Empfänger weiterleitet. Diese Bedienvorrichtungen sind insbesondere zur Verwendung mit Elektrowärmegeräten mit Auflagefläche geeignet, da sie es gestatten, eine Bedienung der Elektrowärmegeräte mittels auf der Glaskeramikplatte angeordneten Bedieneinheiten zu realisieren, ohne dass es erforderlich ist, in der Platte Durchbrechungen vorzusehen.

Die EP 725 181 A1 beschreibt eine Bedienvorrichtung für eine Waschmaschine, bei der an der Vorderseite eine versenkbare Bedienvorrichtung mit mehreren Schaltern vorgesehen ist. Die gesamte Bedienvorrichtung kann in die Vorderseite hineinversenkt werden.

Die WO 2005/066547 A1 beschreibt ein Gargerät und Verfahren zu dessen Steuerung. Dabei weist das Gargerät einen Drehschalter auf samt einem an dem Drehschalter vorgesehenen Druckknopf. Mit dem Drehschalter kann zwischen Parametern gewechselt werden und mit dem Druckknopf kann einer der Parameter ausgewählt bzw. bestimmt werden.

Die GB 2361292 A beschreibt eine Bedienvorrichtung für ein Elektrogerät mit einem Drehregler. Der Drehregler weist verschiedene Bereiche auf, die jeweils unterschiedliche elektrische Leitfähigkeit aufweisen. Sie sind über eine mechanische Drehachse elektrisch direkt mit einem an der Drehachse anliegenden Schleifring verbunden und über diesen an eine Steuerung, wobei sowohl die Drehung des Drehreglers erfasst und ausgewertet werden kann als auch das Berühren eines der beiden Bereiche. Ähnlich beschreibt die US 4,408,172 eine weitere Bedienvorrichtung für ein Elektrogerät mit einem Drehregler, an dessen Drehachse eine Steuerung direkt elektrisch leitend angeschlossen ist.

Als nachteilig an den bekannten Bedienvorrichtungen wird angesehen, dass sie jeweils nur die Registrierung einer Winkelstellung oder einer Positionsänderung gestatten. So sind komplexere Funktionen als die Leistungssteuerung beispielsweise eines Kochfeldes nur schwer zu realisieren.

### Aufgabe und Lösung

Der Erfindung liegt die Aufgabe zugrunde, ein eingangs genanntes Elektrogerät sowie ein eingangs genanntes Bedienverfahren zu schaffen, mit denen Probleme des Standes der Technik vermieden werden können und insbesondere ein Elektrogerät zur Verfügung gestellt wird, welches bezüglich der Bedienbarkeit bzw. des Bedienverfahrens den bisherigen überlegen ist.

Gelöst wird diese Aufgabe durch ein Elektrogerät mit den Merkmalen des Anspruchs 1 sowie ein Bedienverfahren mit den Merkmalen des Anspruchs 21 oder 23. Vorteilhafte sowie bevorzugte Ausgestaltungen der Erfindung sind Gegenstand der weiteren Ansprüche und werden im Folgenden näher erläutert. Der Wortlaut der Ansprüche wird durch ausdrückliche Bezugnahme zum Inhalt der Beschreibung gemacht. Manche der nachfolgend erläuterten Merkmale werden nur einmal beschrieben. Sie gelten jedoch unabhängig davon sowohl für die Bedienvorrichtung als auch für die beiden Bedienverfahren.

Erfindungsgemäß ist auf dem Dreh- oder Schieberegler, der im Folgenden in seiner Allgemeinheit als Drehregler bezeichnet wird, mindestens ein weiteres Schaltmittel vorgesehen, welches zur Signalübertragung eines Schaltvorgangs an ein unter der Auflagefläche angeordnetes Steuergerät ausgebildet ist. Die Bedieneinheit kann einteilig ausgebildet sein, so dass die gesamte Bedieneinheit den Drehregler bildet und bei einem Drehvorgang des Drehreglers in ihrer Gesamtheit gedreht wird. Alternativ dazu ist es möglich, die Bedieneinheit zweiteilig auszubilden, wobei eine auf der Auflagefläche des Elektrogeräts aufliegende Lagervorrichtung während der Bedienung vorzugsweise positions- und winkelstabil angeordnet ist, insbesondere winkelstabil. Bei einer solchen Ausführungsform führt ein Drehen des Drehreglers dazu, dass sich der Drehregler relativ zu der Lagervorrichtung um eine Hauptdrehachse dreht. Die Schaltmittel sind vorteilhaft im Bereich der Oberseite des Drehreglers oder oben darauf vorgesehen. Sie sind dort sehr einfach zugänglich. Da in der Regel eine Bedienung des Drehreglers selbst durch Umfassen von dessen Seitenwandung erfolgt, ist ein versehentliches Auslösen bestimmter Schaltmittel nicht zu befürchten. Es können jedoch auch gerade dort Schaltmittel vorgesehen sein. Bei einer Ausführung der Bedieneinheit mit einer Lagervorrichtung und einem relativ zur Lagervorrichtung verdrehbaren Drehregler wird es als besonders vorteilhaft angesehen, wenn ein Schaltmittel winkelstabil zur Lagervorrichtung ausgebildet sind und dadurch mit dem Drehregler nicht mitgedreht wird. Dies gilt insbesondere dann, wenn es sich um komplexe Schaltmittel handelt, beispielsweise solche, die mehrere Tasten oder Knöpfe umfassen, denen jeweils eine andere Funktion zugewiesen ist. In weiterer Ausgestaltung kann ein Drehregler auch wie bekannt an einer Drehachse eines Regelgeräts wie eines Energiereglers sitzen.

Die Verwendung einer erfindungsgemäßen Bedienvorrichtung mit einem Schaltmittel an oder auf dem Drehregler gestattet eine sichere und bequeme Bedienung des Elektrogerätes. So ist es beispielsweise möglich, die Inbetriebnahme eines Kochfeldes nicht allein über die Winkelstellung bzw. die Position der Bedieneinheit zu steuern, sondern das erfindungsgemäß vorgesehene Schaltmittel als An- und Aus-Schalter für eine Kochstelle auszugestalten. So kann man in eine andere Bedienebene bzw. in einen anderen Betriebsmodus gelangen oder Sonderfunktionen auslösen. Hierdurch wird beispielsweise verhindert, dass durch versehentliches Drehen des Drehreglers eine Kochstelle in Betrieb genommen wird. Eine weitere Funktion des erfindungsgemäßen Schaltmittels kann das Auslösen eines Ankochstoßes oder die Bestätigung einer durch den Regler bestimmten und an einer Anzeige dargestellten Option sein, beispielsweise gerade auch der Start des Betriebs einer selektierten Kochstelle. Es ist von großem Vorteil, wenn durch das weitere Schaltmittel bzw. das entsprechend ausgelegte Bedienverfahren der Drehregler eine weitere Funktionalität erhalten kann.

In einer Weiterbildung der Erfindung ist das Schaltmittel als Druckknopf ausgebildet. Ein solcher Druckknopf stellt die einfachste Form eines Schaltmittels dar. In Kombination mit einem Drehregler sind die Bedienungsmöglichkeiten gegenüber einer Bedieneinheit mit Drehregler ohne Druckknopf deutlich erhöht. Insbesondere kann ein Elektrogerät, welches über eine größere Ausgabevorrichtung verfügt, mit solch einem Drehregler mit Druckknopf vollständig bedient werden. Dabei kann der Drehregler einem Wechsel zwischen Optionen dienen und der Druckknopf zur Bestätigung einzelner Optionen.

Darüber hinaus ist der Druckknopf als Schaltmittel insbesondere bei solchen Bedieneinheiten ohne winkelstabile Lagerungsvorrichtung von Vorteil. Da sich bei diesen Bedieneinheiten durch Verdrehen des Drehreglers mangels Lagerungsvorrichtung zwangsläufig auch das Schaltmittel relativ zur Auflagefläche mitdreht, sind Schaltmittel bei solchen Bedieneinheiten weniger geeignet, deren relative Position zueinander dadurch geändert würde, so dass ein Bediener die gleichen Funktionen nicht immer an gleicher Stelle vorfindet. Es ist möglich, dass der Drehregler insgesamt den Druckknopf oder -schalter darstellt, der gegenüber einer Auflagefläche verdrehbar und senkrecht dazu eindrückbar ausgebildet ist. Hierdurch kann verhindert werden, dass Verunreinigungen in Spalte zwischen Drehvorrichtung und Druckknopf geraten.

In einer Weiterbildung der Erfindung schließt ein Druckknopf bei der Betätigung einen elektrischen Kontakt. Bei dem Druckknopf kann es sich um einen herkömmlichen Mikroschalter handeln, der zwei Kontakte verbindet für eine Signalübertragung an das Steuergerät. Zweckmäßig kann darüber hinaus auch ein elektrisch leitfähiger und vorzugsweise metallischer Druckknopf sein, der durch mechanische Betätigung auf eine bedienseitige Kondensatorplatte gedrückt wird und dann die kapazitive Kopplung bewirkt. Diese ist in einem festen Abstand zu einer auflageseitigen Kondensatorplatte angeordnet. Diese überträgt ein Signal bzw. die Berührung unter die Platte und an einen Empfänger, wie es ähnlich beispielsweise aus der EP 859467 A1 zur kapazitiven Berührungserkennung bekannt ist. Die Empfänger bzw. kapazitiven Sensorelemente unter der Auflagefläche können auch so ausgebildet sein wie dort, also als flexible elektrisch leitfähige Körper.

In einer Weiterbildung der Erfindung ist das Schaltmittel selber ein Berührschalter. Berührschalter sind wirtschaftlich besonders günstig und haben darüber hinaus den Vorteil, dass keine Lagerungen, beispielsweise für einen Druckknopf, in der Bedieneinheit erforderlich sind. Der Berührschalter kann als fest in die Bedieneinheit integrierter Metallkern oder ein Metallteil ausgebildet sein, dessen Einfluss auf eine unter der Auflagefläche befindliche Kondensatorplatte als Sensor durch eine Berührung durch den Bediener beeinflusst wird. Eine entsprechende Bedieneinheit ist quasi vollständig verschleißfrei, da keine elektrischen oder beweglichen Komponenten erforderlich sind. Dies stellt vor allem in Hinblick auf Verschmutzungen solcher Lagerungen einen erheblichen Vorteil dar. Bei einer besonders vorteilhaften Ausbildung der Erfindung sind so durch das zusätzliche Schaltmittel keine weiteren bewegten Teile notwendig, was Kosten reduziert und die Bediensicherheit erhöht.

In einer Weiterbildung der Erfindung ist die Bedienvorrichtung zur Registrierung der Drehstellung bzw. Drehposition des Drehreglers auf der Seite der Bedieneinheit mit einem Magnetanker ausgebildet, der vorzugsweise drehfest mit dem Drehregler verbunden ist. Auf Seite der Auflagefläche sind Magnetsensoren zur Registrierung einer Bewegung des Magnetankers vorgesehen, wobei durch eine Betätigung des Schaltmittels eine Distanz zwischen dem Magnetanker und der Auflagefläche verändert wird. Alternativ kann dies optisch erfolgen durch unterschiedlich gestaltete Unterseiten des Drehknebels und optische Sensoren wie Reflex-Lichtschranken. Eine weitere Alternative sind kapazitiv wirkende Flächen im Drehknebel oben und unter der Auflagefläche, die je nach Drehposition eine unterschiedliche Überdeckung haben.

Das Prinzip der Verwendung eines Magnetankers und Hall-Sensoren zur Registrierung einer Drehung des Drehreglers ist aus der DE 10212953 A1 bekannt, die zu diesem Zweck einen magnetisierten Metallstern als Magnetanker vorschlägt. Durch die Verlagerung des Magnetankers hin zur Auflagefläche oder von der Auflagefläche weg im Zuge einer Betätigung des Schaltmittels wird erreicht, dass die unten liegenden Teile der Bedienvorrichtung gegenüber dem Stand der Technik nicht verändert werden müssen. Die Hall-Sensoren können in Verbindung mit einer Steuerung bei einer Drehbewegung des Drehreglers anhand der Hall-Spannung erkennen, in welchem Schaltzustand des Schaltmittels diese Drehbewegung stattfindet. So kann beispielsweise über eine derartige Bedienvorrichtung ein schnelles Einstellen einer Temperatur und einer Garzeit erfolgen, indem beide Werte über den Drehregler eingestellt werden, wobei dieser für die Einstellung der Garzeit dann heruntergedrückt wird. Anstelle des Herunterdrückens kann hier auch allgemein das weitere Schaltmittel betätigt werden.

In einer Weiterbildung der Erfindung ist die Bedieneinheit zur Signalübertragung eines Schaltvorgangs des Schaltmittels mittels einer Veränderung einer magnetischen und/oder elektrischen Feldstärke unterhalb der Auflagefläche ausgebildet. Diese Veränderung kann durch eine Lageveränderung wie Kippen eines Teils der Bedieneinheit hervorgerufen werden. Hierdurch ist eine besonders einfache Bauweise der Bedieneinheit realisierbar. Ein Schaltvorgang oder Verstellvorgang des Schaltmittels resultiert dabei beispielsweise in einer Verlagerung, einer Kippung um eine horizontale oder vertikale Achse oder aber einer horizontalen Verlagerung oder Drehung, die durch entsprechende Sensoren unterhalb der Auflagefläche ermittelt werden können. Besonders vorteilhaft ist eine Ausgestaltung, bei der ein mit einem Druckknopf gekoppeltes Metallelement in Richtung der Auflagefläche verschoben wird, wobei sowohl der Druckknopf selbst als auch die Verbindung des Druckknopfes mit dem Metallelement leitend ausgebildet sind.

Dadurch wird eine unmittelbar leitende Verbindung zwischen dem Bediener und dem Metallelement im Augenblick der Bedienung geschaffen. Die Verlagerung des Metallelements kann dann durch eine unterhalb der Auflagefläche angeordnete Kondensatorplatte anhand der sich dadurch verändernden Kapazität der Kondensatorplatte ermittelt werden. Eine derartige Anordnung ist in ähnlicher Art und Weise auch für einen Schalter mit mehr als zwei Schaltpositionen denkbar, indem die Distanz des Metallelements von der Auflagefläche von der gewählten Schalterstellung abhängig ist. In diesem Fall kann aus der Kapazität der Kondensatorplatte auf die Schaltstellung geschlossen werden. Diese bedieneinheitseitig rein mechanische Realisierung des Schaltmittels ist insbesondere aufgrund geringer Kosten und hoher Zuverlässigkeit vorteilhaft.

Der Drehregler kann beleuchtbar sein bzw. Leuchtmittel aufweisen, vorteilhaft im Bereich der Schaltmittel zu deren Markierung. Die Leuchtmittel können LED sein. Eine Energieversorgung kann bevorzugt durch kontaktlose Energieübertragung erfolgen, vorzugsweise induktiv bzw. mit Induktionsspulen wie im vorigen Abschnitt beschrieben.

Alternativ zu einem abnehmbaren Drehregler kann die Bedienvorrichtung bzw. der Drehregler mittels einer ortsfesten Drehachse gehaltert sein. Diese verläuft durch eine entsprechende Bohrung in der Blende oder Auflagefläche des Elektrogeräts. Die Achse kann an einem Einstellgerät wie einem Potentiometer, Grey-Code-Schalter oder Energieregler sitzen. Eine Signalübertragung kann mittels bzw. an der Achse erfolgen bzw. verlaufen. Dazu kann ein elektrischer Leiter vorgesehen sein, beispielsweise ein an der Achse längs verlaufender Leiter bzw. Draht. Der Leiter kann auch eingespritzt sein.

Bevorzugt ist die Drehachse am Drehregler mit einem Schaltmittel im Drehregler verbunden, vorzugsweise mittels einer direkten elektrischen Verbindung. Ein solches Schaltmittel kann wie vorbeschrieben ausgebildet sein.

Ein elektrischer Leiter an der Achse kann am unteren Ende mit einer Kondensatorplatte samt Gegenkondensatorplatte verbunden sein. Ein elektrischer Leiter an der Achse kann in einem mittleren Bereich mit einer ersten Kondensatorfläche entlang des Achsumfangs verbunden sein. Dabei ist die erste Kondensatorfläche mit geringem Abstand von einer weiteren zweiten Kondensatorfläche umgeben. So kann eine kapazitive Signalübertragung stattfinden.

In weiterer Ausgestaltung kann der Drehregler mehrstufig mit unterschiedlichem bzw. abnehmendem Durchmesser ausgebildet sein. Vorteilhaft weist er einen ersten Knebel-Abschnitt mit großem Durchmesser als Unterteil und einen zweiten Knebel-Abschnitt darauf mit kleinem Durchmesser als Oberteil auf. So kann am großen ersten Knebel-Abschnitt eine Feineinstellung vorgenommen werden. Am kleineren zweiten Knebel-Abschnitt kann eine schnelle Grobeinstellung vorgenommen werden. Wenn jeder Knebel-Abschnitt mit unterschiedlichen Schaltmitteln verbunden ist bzw. diese aufweist, kann so auch noch eine jeweils unterscheidbare Bedienung vorgenommen werden.

In nochmals weiterer Ausgestaltung kann der Drehregler in die Blende bzw. Auflagefläche des Elektrogeräts hinein versenkbar ausgebildet sein, vorzugsweise mittels einer zweiteiligen Drehachse, die nach Art eines Teleskops ineinander geschoben werden kann. Im eingeschobenen Zustand steht der Drehregler vorteilhaft nicht über die Blende bzw. Auflagefläche über. Die sonstige Funktionalität kann er über die Drehachse weiterhin haben.

Diese und weitere Merkmale gehen außer aus den Ansprüchen auch aus der Beschreibung und den Zeichnungen hervor, wobei einzelne Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischenüberschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine erste Ausführungsform eines erfindungsgemäßen Elektrogeräts mit einer Bedienvorrichtung in einer Schnitt- darstellung in unbetätigtem Zustand des Schaltmittels,
- Fig. 2 und 3: eine zweite Ausführungsform eines erfindungsgemäßen Elektrogeräts mit einer Bedienvorrichtung in einer Schnittdarstellung und Draufsicht,
- Fig. 4: eine nicht zur beanspruchten Erfindung gehörende dritte Ausführungsform eines Elektrogeräts mit einer Bedienvorrichtung in einer teilweise geschnittenen Darstellung in unbetätigtem Zustand des Schaltmittels.
- Fig. 5: eine Abwandlung der Ausführungsform nach Fig. 2 mit optischer Drehpositionserkennung,
- Fig. 6: eine vierte Ausführungsform als Abwandlung derjenigen aus Fig. 2 in Draufsicht mit anderer Übertragung eines Schaltsignals von einem Drehknebel an die Unterseite der Glaskeramikplatte samt Erkennung der Drehposition darüber,
- Fig. 7: eine fünfte Ausführungsform als Abwandlung derjenigen aus Fig. 6 mit Übertragung von zwei von der Drehposition unabhängigen Schaltsignalen,
- Fig. 8: eine sechste Ausführungsform als weitere Abwandlung mit einem Drehregler mit feststehender Drehachse durch eine Abdeckung hindurch und kapazitiver Erfassung einer Berührung und
- Fig. 9: eine Abwandlung einer Bedienvorrichtung nach Fig. 8 mit einem stufig ausgebildeten Drehknebel.

### Detaillierte Beschreibung der Ausführungsbeispiele

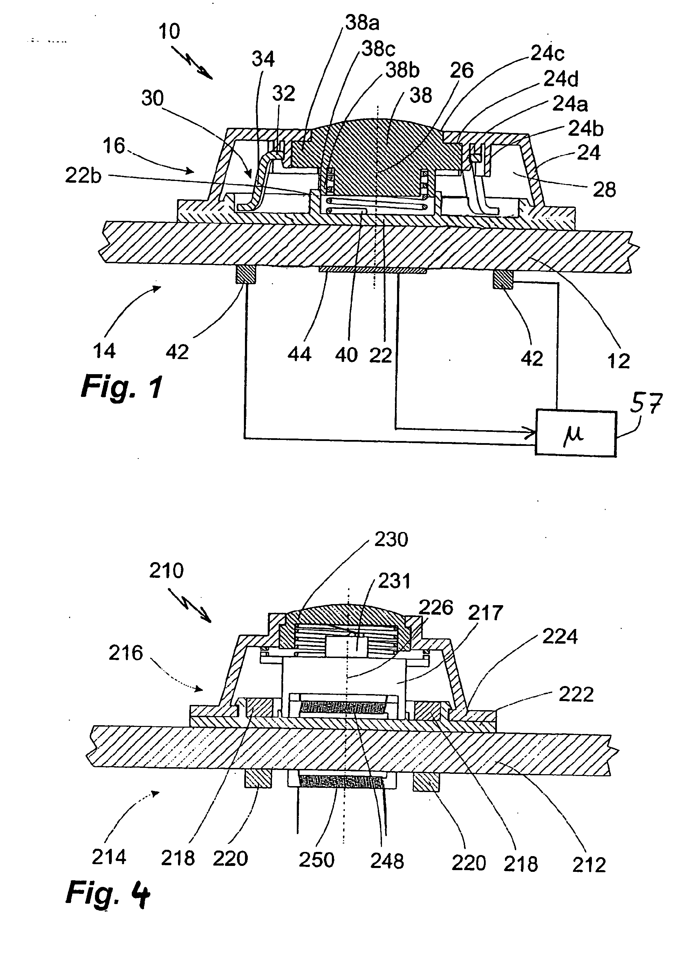

Die Fig. 1 zeigt eine erste Ausführungsform eines erfindungsgemäßen Elektrogeräts mit einer Bedienvorrichtung. Diese Bedienvorrichtung 10 ist an einer Glaskeramikplatte 12 vorgesehen als Bedienvorrichtung für ein Kochfeld. Sie besteht aus stationären Vorrichtungselementen 14, die an der Unterseite der Glaskeramikplatte 12 befestigt sind, sowie aus einer Bedieneinheit 16, die von oben aufgesetzt ist. Die Bedieneinheit 16 ist an definierter Position auf der Glaskeramikplatte 12 durch eine Magnetkraftwirkung gehalten, die durch nicht dargestellte Magnete erzeugt werden kann, und um eine Drehachse 26 drehbar. Beispielsweise kann hier jeweils ein zentral angeordneter Magnet vorgesehen sein. Alternativ kann die Bedieneinheit eine Lagerungsvorrichtung aufweisen, wie sie nachfolgend noch erläutert wird.

Im durch den Drehregler 24 gebildeten Gehäuseinnenraum 28 ist ein magnetisierter Metallstern 30 fest angeordnet. Der Metallstern 30 besteht aus einem Innenring 32 sowie insgesamt fünf vom Innenring 32 sich nach außen und unten erstreckenden Fortsätzen 34. Die Fortsätze 34 sind magnetisch aktiv oder mit kleinen Magneten besetzt, so dass die Bewegung des Metallsterns über Hall-Sensoren registrierbar ist. Zur Befestigung des Metallsterns 30 an dem Drehregler 24 ist eine Rastverbindung vorgesehen, alternativ ist ein Verkleben oder Vergießen des gesamten Drehreglers möglich.

In der Mitte des Drehreglers 24 ist eine Aussparung 24c vorgesehen, in die von unten ein metallischer Druckknopf 38 eingesetzt ist. Der Druckknopf 38 weist eine radiale Aufweitung 28a auf, die mit Anschlagsflächen 24d des Drehreglers 24 derart zusammenwirken, dass der Druckknopf 38 im Gehäuseinneren 28 gehalten wird. An der Unterseite 22 ist eine Schraubenfeder 40 eingesetzt um den Druckknopf 38 von unten gegen die Oberseite des Drehreglers 24 zu drücken.

Die in Fig. 1 dargestellte Bedieneinheit 16 weist also zwei Möglichkeiten der Betätigung auf. Gemäß der ersten Möglichkeit kann der Drehregler 24 gedreht werden, wobei der Metallstern 30 mitgedreht wird. Die Bewegung der magnetisierten Fortsätze 34 wird durch unter der Glaskeramikplatte 12 angeordnete Hall-Sensoren 42 registriert. Zur Auswertung sind die Hall-Sensoren 42 mit einer schematisch dargestellten Steuerung 57 verbunden, welche die Betätigung im Sinne einer Leistungsanpassung oder Funktionsänderung eines Kochgerätes bzw. Kochfeldes umsetzt.

Die zweite Möglichkeit der Betätigung besteht darin, dass der Druckknopf 38 gegen die Feder 40 heruntergedrückt wird, so dass er nahezu an der Lagerungsvorrichtung 22 anliegt. Hierdurch wird die Kapazität einer unter der Glaskeramikplatte angeordneten Kondensatorplatte 44 verändert, vor allem dadurch, dass der metallische Druckknopf 38 den Finger einer Bedienperson elektrisch an die Kondensatorplatte ankoppelt. Die Veränderung wird von der damit verbundenen Steuerung 57 registriert, welche mit der Kondensatorplatte 44 verbunden ist. Als Auswerteverfahren kann das aus der vorgenannten EP 859467 A1 bekannte angepasst werden. Anstelle des separaten radial inneren Druckknopfes kann auch der gesamte obere Teil des Drehreglers 24 gegen eine Federkraft odgl. heruntergedrückt werden, um eine Annäherung an die Kondensatorplatte 44 zu erreichen.

Als weitere Alternative kann der Druckknopf auch mehrteilig sein, beispielsweise zweigeteilt. Eine solche Zweiteilung kann radial bzw. konzentrisch sein, in zwei oder mehr Teile, beispielsweise zwei Hälften. Hier kann über die unterschiedlich große angedrückte Fläche oberhalb der Kondensatorplatte von der Steuerung erkannt werden, welcher Teil bzw. wie viele Teile herabgedrückt sind.

Die dargestellte Bedienvorrichtung 10, bestehend aus der Bedieneinheit 24 sowie den an der Glaskeramikplatte 12 fest vorgesehenen Elementen 14 der Bedienvorrichtung, ist bezüglich ihres Aufbaus günstig und bezüglich ihrer Funktion sehr zuverlässig. Durch die Schaltfunktion des Druckknopfs 38 als mechanisch arbeitendes Schaltmittel lassen sich Funktionalitäten wie das An- und Ausschalten einer Kochplatte oder auch das Auslösen eines Ankochstoßes sehr gut realisieren, ebenso sonstige Eingaben.

Bei einer Abwandlung der Signalübertragung der Bedienung des weiteren Schaltmittels ist unter der Glaskeramikplatte 12 eine optische Reflexlichtschranke angeordnet. Diese kann den Abstand zu der Unterseite des Knopfes 38 erfassen. Ist er oben, wird es als ein Betätigungszustand angesehen. Ist er heruntergedrückt, so wird es als weiterer Betätigungszustand angesehen. Also kann auch so ein weiteres Schalten erfolgen. Alternativ zu einer optischen Reflexlichtschranke kann ein sonstiger Näherungssensor verwendet werden.

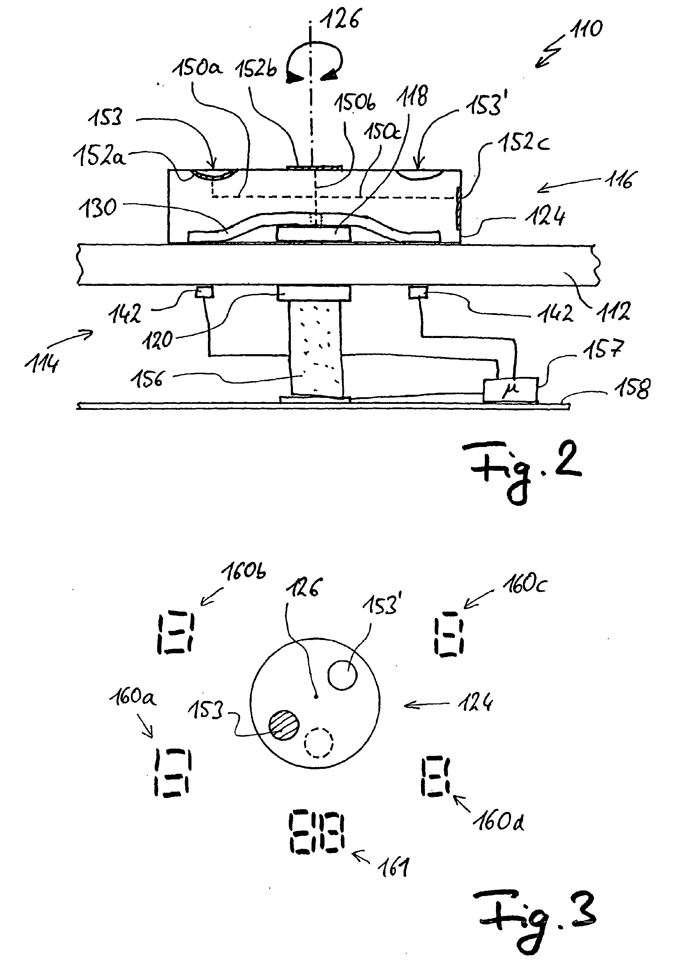

Fig. 2 zeigt eine Abwandlung einer Anordnung ähnlich Fig. 1. Eine Bedienvorrichtung 110 ist an einer Glaskeramikplatte 112 vorgesehen. Die Bedieneinheit 116 ist wiederum als eine Art Drehknebel 124 ausgebildet und kann um die Drehachse 126 gedreht werden. Die Lagerung erfolgt durch einen zentralen Magneten 118 im Drehknebel sowie einen gegenüberliegenden Magneten 120 unter der Glaskeramikplatte 112. Oberhalb des Magneten 118 verläuft in dem Drehknebel 124 ein Blech- oder Metallstern 130. Dieser ist beispielsweise fünfarmig und ist derart mit dem Magneten 118 verbunden, dass die einzelnen Arme des Metallsterns 130 ebenfalls magnetisch sind. Mit den Hall-Sensoren 142 unter der Glaskeramikplatte kann so die Drehstellung ermittelt werden.

Der Magnet 118 ist mit drei gestrichelt dargestellten elektrisch leitfähigen Verbindungen 150a-c elektrisch leitfähig mit verschiedenen elektrisch leitfähigen oder metallischen flächigen Berührsensoren 152a-c verbunden. Diese Darstellung ist nur schematisch und soll verschiedene Anordnungen der Berührsensoren 152 veranschaulichen. In der Praxis wird üblicherweise nur einer der Berührsensoren 152 samt der entsprechenden Verbindung 150 vorgesehen.

Der untere Magnet 120 ist über einen elastischen und elektrisch leitfähigen Kunststoffkörper 156 elektrisch mit einer Steuerung 157 auf einer Leiterplatte 158 verbunden. Mit dieser Steuerung 157 sind auch die Hall-Sensoren 142 verbunden.

Berührt nun eine Bedienperson einen der Berührsensoren 152, so entsteht eine elektrische Verbindung zwischen dem Berührsensor und dem zentralen Magneten 118. Dies kann über kapazitive Kopplung zwischen den als elektrisch leitfähige Flächen wirkenden Magneten 118 und 120 sowie die elektrische Verbindung 156 an die Steuerung 157 gegeben werden. Diese kann also das Berühren eines der Berührsensoren erkennen durch die Glaskeramikplatte 112 hindurch nach dem Funktionsprinzip eines kapazitiven Berührsensors, wie es beispielsweise in der vorgenannten EP 859467 A1 beschrieben ist. Da sich der Drehknebel 124 stets um seine Mittelachse 126 dreht und sich somit die beiden Magnete 118 und 120 nicht zueinander bewegen bzw. nicht auseinander, ist die Zuordnung stets gleich und die Erkennung der Berührung funktioniert immer. In diesem Fall ist also der Berührsensor 152 im Zusammenwirken mit dem Magneten 118 das erfindungsgemäße Schaltmittel, und zwar ein sogenannter Berührschalter.

An welcher der gezeigten Stellen an dem Drehknebel 124 der Berührsensor 152 angebracht wird kann vom jeweiligen Verwendungszweck abhängen. Der Vorteil bei einer radial außen und oben liegenden Vertiefung 153 wie beim Berührsensor 152a liegt darin, dass mit einem Finger in diese Vertiefung 153 eingegriffen werden kann und dann der Drehknebel 124 sowohl in kleinen Winkeln als auch beliebig weit in großen Winkeln, unter Umständen sogar mit mehreren Umdrehungen, gedreht werden kann. Befindet sich mit gleichem radialem Abstand gegenüber eine weitere Vertiefung 153', diese jedoch ohne Funktion bzw. ohne Berührsensor, so kann über eine der beiden Vertiefungen eine Drehung erfolgen mit der Auswahl, dabei eine Schaltfunktion auszulösen oder nicht.

Das Vorsehen des Berührsensors 152b in der Mitte weist den Vorteil auf, dass neben einer sehr guten separaten Betätigung ähnlich einem normalen Berührschalter ohne Drehbewegung ebenfalls für kleine Drehwinkel eine Betätigung bei gleichzeitiger Drehung möglich ist. Für den an der Außenseite angebrachten Berührsensor 152c gilt ähnliches. Unter Umständen ist es bei einer Ausführung der Erfindung auch möglich, zwei solche an unterschiedlicher Stelle angebrachte Berührsensoren vorzusehen. Die Unterscheidung, welcher der Berührsensoren berührt worden ist, kann dann über eine weitere folgende Verschaltung erfolgen, wie zuvor erläutert worden ist.

Der Vorteil einer solchen Ausführung des Drehknebels 124 ist der, dass keinerlei bewegten Teile vorzusehen sind und das gesamte Innenleben beispielsweise mit Kunststoff ausgegossen werden kann. So wird ein robuster und kostengünstig herstellbarer Drehknebel geschaffen.

In der Draufsicht gemäß Fig. 3 auf eine Bedienvorrichtung 110 entsprechend Fig. 2 ist zu erkennen, wie durch LED-Siebensegmentanzeigen 160a-d Kochstufenanzeigen für vier Kochstellen an entsprechender Position eines Kochfeldes an der Glaskeramikplatte 112 dargestellt werden können. Unterhalb der Anzeigen 160a und 160d ist eine weitere zweistellige LED-Siebensegmentanzeige 161 für eine Timerfunktion vorgesehen. Durch den schraffiert dargestellten Berührsensor 152a am Drehknebel 124 kann nicht nur eine Relativdrehung erkannt werden, sondern auch eine absolute Winkelstellung. Des Weiteren kann durch den Berührsensor 152a als Schaltmittel entweder eine einzelne Funktion zuoder abgeschaltet werden. Alternativ ist es möglich, dass bei Drehung des Drehknebels 124 mit gleichzeitigem Berühren des Berührsensors 152a in einem ersten Modus eine der Kochstellen selektiert wird. Bei einer solchen Drehung werden also unter Umständen entsprechend dem Drehwinkel nacheinander die Anzeigen 160a-160d in einen Selektionsmodus schalten, was durch Blinken angezeigt werden kann. Dies geht so lange, wie der Berührsensor 152a berührt wird, was über die zu Fig. 2 beschriebene Berührschalteranordnung erkannt werden kann.

Wird der Berührsensor 152a nicht mehr berührt, so erkennt dies die Steuerung 157 und kann in einen anderen Modus schalten, insbesondere einen Modus zur Leistungseinstellung einer selektierten Kochstelle. Nun kann also durch Drehen des Drehknebels 124 ohne Berühren der Sensorfläche 152a die Leistung an der selektierten Kochstelle erhöht oder verringert werden, was an der entsprechenden Anzeige 160 dargestellt wird. Ist die gewünschte Leistung eingestellt, so kann entweder automatisch bzw. zwingend folgend der Betrieb der Kochstelle mit dieser Leistungsstufe einsetzen. Alternativ kann vorgesehen sein, dass noch einmal kurzzeitig der Berührsensor 152a ohne Drehen berührt wird als eindeutiges Signal an die Steuerung 157, nun den Betrieb entsprechend mit der eingestellten Leistungsstufe zu starten.

Um eine durch die Anzeige 161 dargestellte Timerfunktion zu aktivieren kann entweder vorgesehen sein, dass beim Selektiervorgang einer Kochstelle durch Drehen im Wechsel auch die Anzeige 161 aktiviert wird, beispielsweise durch Blinken. Nach Loslassen des Berührsensors 152a kann sie dann in der Höhe eingestellt werden. Alternativ kann vorgesehen sein, dass in Abwandlung des vorbeschriebenen Verfahrens nach Einstellen der Leistungshöhe durch erneutes Berühren des Berührsensors 152a und Drehen automatisch für die gerade bezüglich ihrer Leistung eingestellte Kochstelle die Timerfunktion eingestellt wird.

Ist das Erkennen einer unterschiedlichen Betätigung unterschiedlicher Berührsensoren möglich, so kann in den vorbeschriebenen verschiedenen Ebenen eine Einstellung durch Drehen des Drehknebels 124 und durch Berührung des jeweiligen Berührsensors gewechselt werden.

Fig. 4 zeigt eine dritte Ausführungsform einer Bedienvorrichtung 210, die nicht zur beanspruchten Erfindung gehört. Auch bei dieser Bedienvorrichtung sind an einer Glaskeramikplatte 212 befestigte Bestandteile 214 der Bedienvorrichtung 210 vorgesehen. Wie auch bei den in den Fig. 1 bis 3 dargestellten Bedienvorrichtungen 10 und 110 weist die Bedienvorrichtung 210 darüber hinaus eine Bedieneinheit 216 auf, die durch die Magnete 218 und 220 sicher auf der Glaskeramikplatte 212 gehalten ist. Anders als bei den Ausführungsformen der Bedienvorrichtung gemäß den Fig. 1 bis 3 weist die in Fig. 4 dargestellte Bedieneinheit statt plattenseitiger Signalmittel zur unmittelbaren Erkennung von Lagerveränderungen von Teilen der Bedieneineinheit einen Mikroprozessor innerhalb der Bedieneinheit auf in einem Mikroprozessorgehäuse 217. Dieser Mikroprozessor registriert zum einen die Drehstellung eines Drehreglers 224 gegenüber einer Lagerungsvorrichtung 222, mit der das Mikroprozessorgehäuse 217 fest verbunden ist. Zum anderen registriert der Mikroprozessor auch den Schaltzustand eines Druckknopfs 230, der im betätigten Zustand einen Mikroschalter 231 auslöst.

Die Energieversorgung des Mikroprozessors erfolgt über zwei Spulen 248 und 250, durch die der Mikroprozessor von unten induktiv mit Energie versorgt wird. Diese Spulen dienen darüber hinaus der Signalübermittlung vom Mikroprozessor zu einer nicht dargestellten Steuerung des Elektrogerätes. Eine solche Energie- und auch Signalübertragung ist dem Fachmann grundsätzlich bekannt. Als besonders vorteilhaft wird dabei ein Wechselmodus angesehen, bei dem abwechselnd eine Energiezuführung zum Mikroprozessor und ein Sendemodus des Mikroprozessors stattfindet. Um den Mikroprozessor während des Sendemodus mit Strom zu versorgen, kann im Mikroprozessorgehäuse 217 ein Kondensator oder anderer Energiespeicher vorgesehen sein. Obwohl die in Fig. 4 dargestellte Ausführungsform nur einen einfachen Druckknopf als Schaltmittel aufweist, ist die Ausführungsform mit einem bedieneinheitseitigen Mikroprozessor besonders geeignet, um auch bei komplexeren Schaltmitteln eine Signalübertragung des Schaltzustandes an das Steuergerät des Elektrogeräts zu realisieren. Die Energieversorgung über die Spulen kann auch dazu genutzt werden, nicht dargestellte Leuchtmittel im Drehregler 224 zu versorgen. Dies können LED sein für verschiedene Anzeigen, wobei diese auch über den Mikroprozessor gesteuert werden können, beispielsweise in Abhängigkeit vom Betätigungszustand des Druckknopfs als Schaltmittel.

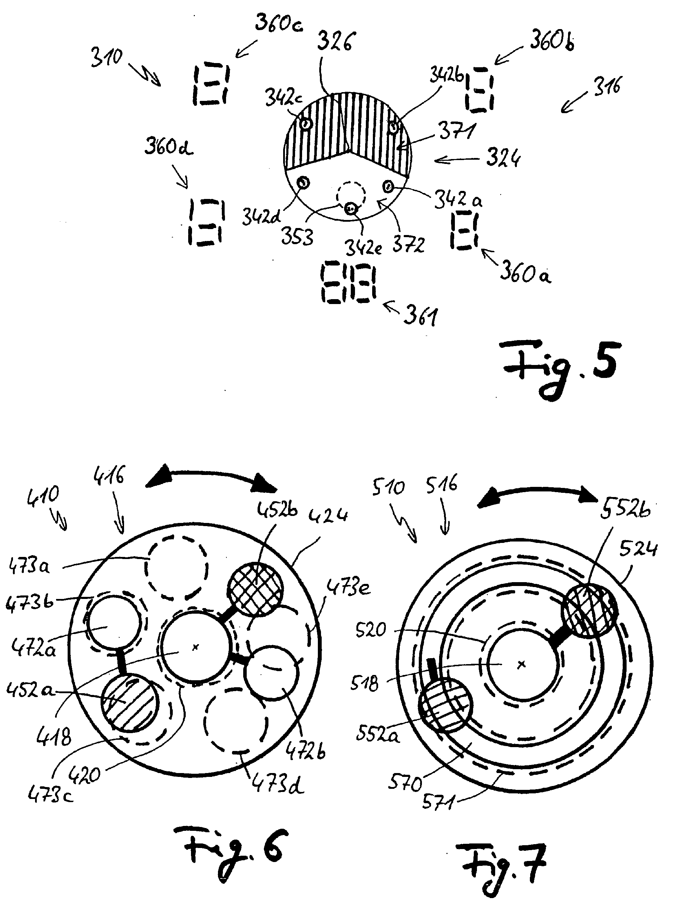

Unter Umständen ist es wünschenswert, dass beispielsweise bei Bezug auf den Berührsensor 152a gemäß Fig. 2 dieser entsprechend einer sonst bei Drehknebeln üblichen Markierung genau auf die Anzeige 160 für eine Kochstelle zeigt, welche gerade selektiert sein soll. Dazu ist es erforderlich, dass nicht nur eine relative Drehung erfasst werden kann, sondern auch der absolute Drehwinkel bzw. die absolute Drehposition. Dies kann erreicht werden durch eine Anordnung, wie sie in Fig. 5 schematisch dargestellt ist. Anstelle der magnetischen Erfassung der Drehstellung gemäß Fig. 2 ist hier die Unterseite des Drehknebels 324 in einem oberen Flächenbereich 371 schwarz oder nicht-reflektierend eingefärbt, was durch die entsprechende Schraffierung verdeutlicht ist. In dem unteren Flächenbereich 372, der einen deutlich kleineren Winkel von etwa 145° einschließt, ist die Unterseite des Drehknebels 324 weiß bzw. reflektierend eingefärbt. Fünf optische Sensoren 342 sind in der dargestellten Position unter der Glaskeramikplatte anstelle der Hall-Sensorik angeordnet und arbeiten beispielsweise als Reflex-Lichtschranken. Diese optischen Sensoren 342 können erkennen, ob sich über ihnen ein dunkler Bereich 371 oder ein heller Bereich 372 befindet. Durch die Anordnung der Sensoren 342 sowie die Aufteilung der Flächen 371 und 372 kann die Winkelposition des Drehknebels 324 zwar nicht mit besonders hoher Genauigkeit auf wenige Grad, aber ausreichend genau erkannt werden. Über die eindeutige Anordnung des Berührsensors gemäß Fig. 4 an dem Drehknebel 324 kann nun eingestellt sein, dass die Steuerung genau weiß, auf welche Stelle bzw. zu welcher Anzeige 160 der Berührsensor oder eine andere Markierung zeigt. Somit kann so noch schneller und einfacher eine entsprechende Kochstelle selektiert und ihre Leistung eingestellt werden.

Anstelle einer hier dargestellten Aufteilung in zwei unterschiedlich reflektierende Flächen kann auch eine noch feinere oder anders ausgestaltete Aufteilung vorgesehen sein. Dies ist im Einzelfall auch auf die Zahl der unterschiedlich zu erkennenden Drehstellungen sowie den Verwendungszweck abzustellen.

In Fig. 6 ist eine Abwandlung der Ausführungsform nach Fig. 2 dargestellt und zwar in schematischer Draufsicht. Die Bedienvorrichtung 410 weist auf einer nicht dargestellten Glaskeramikplatte eine Bedieneinheit 416 in Form des Drehknebels 424 auf. In durchgezogenen Linien sind der zentrale Magnet 418 im Drehknebel 424 und zwei Außenelektroden 472a und 472b als ebenfalls elektrisch leitende Fläche dargestellt. Die Außenelektroden 472 sind als metallische Flächen vorteilhaft möglichst nahe an der Unterseite des Drehknebels 424 vorgesehen, beispielsweise als entsprechende Metallteile. Die Außenelektroden 472 sind ebenso wie der zentrale Magnet 418 nach Art der Darstellung aus Fig. 2 und 3 mit dargestellten Berührsensoren an der Oberseite des Drehknebels 424 verbunden. So ist eine Berührfläche 452a in der Vertiefung unten links wie dargestellt mit der Außenelektrode 472a verbunden und die Berührfläche 452b in der Vertiefung oben rechts wie dargestellt mit der Außenelektrode 472b und dem zentralen Magnet 418. Der Magnet 418 und die Außenelektrode 472b können auf demselben Metallteil als Halterung und elektrische Verbindung angeordnet sein.

Gestrichelt dargestellt sind die Teile der Bedienvorrichtung 410, die unter einer Glaskeramikplatte angeordnet sind. Dies sind der andere zentrale Magnet 420 und die unteren Außenelektroden 473a-e zum Zusammenwirken mit der Außenelektrode 472b. Vorteilhaft bilden diese in entsprechender Anzahl einen konzentrischen umlaufenden Ring, so dass beim Drehen des Drehknebels 424 die oberen Außenelektroden 472a und b stets oberhalb der unteren Außenelektroden 473a-e umlaufen.

Die Funktion ist folgendermaßen: Wie bereits zur Fig. 2 beschrieben wird eine Berührung des mit dem zentralen Magneten 418 verbundenen Berührsensors 452b stets an den unteren Magneten 420 übertragen und kann so erkannt werden.

Die obere Außenelektrode 472a befindet sich während der Drehung stets über einer der unteren Außenelektroden 473a-e. So kann durch Auswerten sämtlicher unterer Segmentelektroden 473 überprüft werden, welche ein entsprechendes Signal von der darüber befindlichen oberen Außenelektrode 472a empfängt. So ist eine Erfassung und Bestimmung der Drehposition möglich, und zwar in Abweichung von Fig. 5 kapazitiv. Berührt eine Bedienperson den mit der Außenelektrode 472a verbundenen Berührsensor 452a und dreht diesen entsprechend Fig. 5 auf eine Anzeige für eine Kochstelle, so wird dies an der an dieser Drehposition vorhandenen unteren Außenelektrode 473 erkannt. So kann beispielsweise bei einem Bedienverfahren diese Kochstelle durch die genaue Drehposition des Drehknebels 424 selektiert werden. Der Vorteil einer solchen Selektion ist auch darin zu sehen, dass dann nicht nur mit dem Berührsensor als Markierung odgl. auf die entsprechende Anzeige einer Kochstelle gewiesen wird, sondern gleich der an diesem Berührsensor anliegende Finger dorthin weist. Dies ermöglicht eine besonders instinktive richtige Bedienung.

Anschließend kann mit dem Finger auf den anderen Berührsensor 452b gewechselt werden, was an einer der unteren Außenelektroden 473 erfasst und auch über die Verbindung zum zentralen Magnet 418 an dem unteren Magnet 420 kapazitiv erfasst werden kann. Hier kann wiederum ein Drehen erfasst werden, insbesondere beispielsweise als Leistungseinstellung zu der gerade selektierten Kochstelle, bei dem zusätzlich der mittlere Berührsensor berührt und betätigt ist. Es sind somit zwei Berührsensoren betätigt. Dies kann auch so kapazitiv erfasst werden.

Durch die Anordnung der oberen Außenelektrode 452a und b und der unteren Außenelektroden 473a-e ist es sogar möglich, allgemein eine Erfassung der Drehposition vorzunehmen für alle Einstellungen mit dem Drehknebel 424, bei dem die Drehposition ausschlaggebend ist. Damit kann unter Umständen auf den Metallstern sowie vor allem auf die teuren und aufwändigen Hall-Sensoren gemäß Fig. 2 verzichtet werden.

Wird für die Erkennung der Betätigung eines Schaltmittels mit Berührsensor beispielsweise gemäß Fig. 2 sowieso eine Auswerteschaltung für einen kapazitiven Berührsensors benötigt, so stellt es einen geringen Aufwand dar, eine Vielzahl ähnlich arbeitender Berührsensoren auszuwerten. Dies kann einfach durch einen Multiplexer erfolgen. So ist es beispielsweise möglich, wenn ein Berührsensor 152 in einer Vertiefung 153 entsprechend Fig. 2 mit einer oberen Außenelektrode 452 gemäß Fig. 6 verbunden ist und der Finger in die Vertiefung gelegt wird zum Drehen des Drehknebels 424, die Drehposition und damit auch einen Drehvorgang oder Drehwinkel zu erfassen. Weitere Funktionen wie das Wechseln in eine andere Ebene des Bedienverfahrens oder Bestätigen einer ausgewählten Funktion kann über den Wechsel zwischen den Berührsensoren 452a und b erfolgen.

In weiterer Ausgestaltung ist es auch noch möglich, mehrere Berührsensoren im Drehknebel vorzusehen und diese mit weiteren Außenelektrode, ähnlich der Außenelektroden 452 gemäß Fig. 6 zu verbinden. Diese weiteren Außenelektroden können sich dann aber von den gezeigten dadurch unterscheiden, dass sie eine doppelte, dreifache oder vierfache Breite aufweisen, also erheblich größer sind. So ist wiederum durch Erfassen der Überdeckung bzw. gleichzeitigen Betätigung der unteren Außenelektroden 473a-e ein jeweils unterschiedliches Signal möglich, wodurch wiederum eine Vielzahl von zusätzlichen Schaltmitteln in Form der zusätzlichen Berührsensoren geschaffen werden kann. Eine Auswertung ist auch hierbei relativ sicher und einfach möglich.

In Fig. 7 ist eine Abwandlung der Ausführungsform nach Fig. 6 dargestellt und zwar in schematischer Draufsicht. Die Bedienvorrichtung 510 weist auf einer nicht dargestellten Glaskeramikplatte eine Bedieneinheit 516 in Form des Drehknebels 524 auf. In durchgezogenen Linien sind dargestellt der zentrale Magnet 518 im Drehknebel 524 und eine konzentrisch dazu verlaufende elektrisch leitende Ringelektrode 570. Die Ringelektrode 570 ist eine metallische Flächen vorteilhaft möglichst nahe an der Unterseite des Drehknebels 524 und dennoch sowohl nach unten als auch gegen den Magnet 518 isoliert, beispielsweise als entsprechendes Metallteil. Die Ringelektrode 570 ist mit dem Berührsensor 552a und der zentrale Magnet 518 mit dem Berührsensor 552b verbunden. Die Berührsensoren können in Vertiefungen an der Oberseite des Drehknebels 524 angeordnet sein.

Gestrichelt dargestellt sind Teile der Bedienvorrichtung 510, die unter einer Glaskeramikplatte angeordnet sind. Dies sind der andere zentrale Magnet 520 und eine zweite untere Ringelektrode 571, die die erste Ringelektrode 570 im Drehknebel etwas überdeckt.

Die Funktion ist folgendermaßen: Wie bereits vorher beschrieben wird eine Berührung des mit dem zentralen Magneten 518 verbundenen Berührsensors 552b an den unteren Magneten 420 übertragen und kann so erkannt werden. Da die obere Ringelektrode 570 stets in Überdeckung mit der unteren Ringelektrode 571 ist, ähnlich wie die beiden Magnete, kann eine Berührung des mit der oberen Ringelektrode 570 verbundenen Berührsensors 552a ebenso nach unten übertragen werden. Die Übertragung über den zentralen Magneten 518 und die obere Ringelektrode 570 funktioniert also stets unabhängig von der Drehposition des Drehknebels 524.

Bei der Bedienung wird dann durch Drehen durch Funktionen sozusagen hindurchgescrollt und anschließend über einen der Berührsensoren 552a oder b eine Eingabe gemacht als Schaltfunktion. Dabei ist es möglich, den Berührsensor 552a bei der Drehung betätigt zu lassen durch Berührung. Mit dem Berührsensor 552b kann dann im Wechsel eine Bestätigung erfolgen.

Die Erkennung einer Drehposition kann gemäß Fig. 5 optisch erfolgen. Alternativ kann eine Erkennung nach Fig. 2 erfolgen. In einer besonders aufwändigen Ausführung kann auch eine Kombination mit Fig. 6 erfolgen, wobei einerseits eine Drehposition mit und ohne weitere Schaltfunktion erfasst werden kann und über die Ringelektrode eine stellungsunabhängige weitere Schaltfunktion.

In weiterer Ausgestaltung ist es auch noch möglich, mehrere Berührsensoren im Drehknebel vorzusehen und diese mit weiteren Ringelektroden zu verbinden. So kann ebenfalls eine Vielzahl von zusätzlichen Schaltmitteln in Form der zusätzlichen Berührsensoren geschaffen werden. Eine Auswertung ist auch hierbei relativ sicher und einfach möglich.

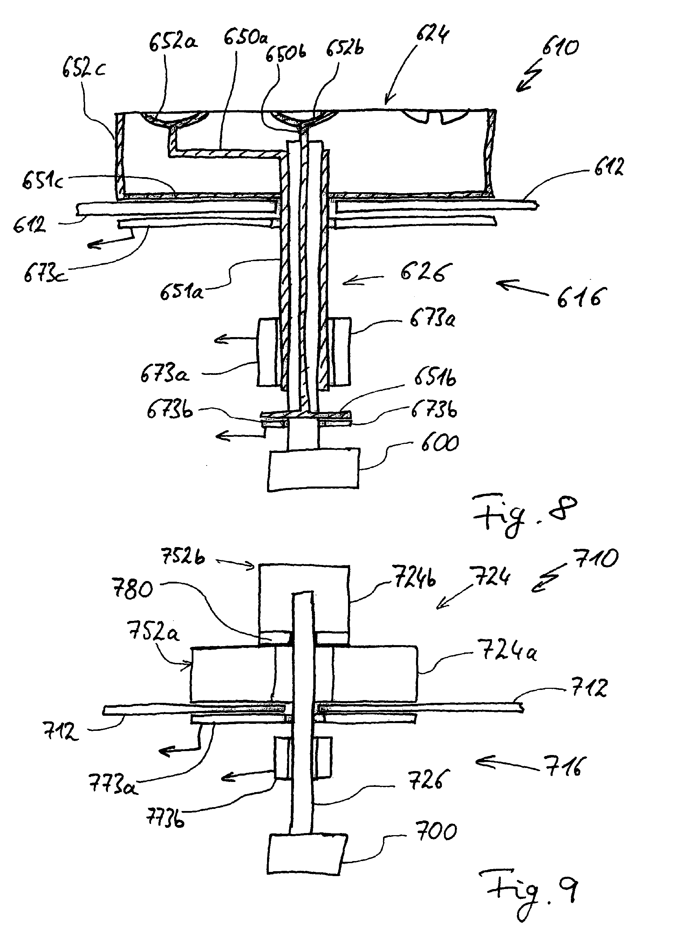

In Fig. 8 ist eine weitere erfindungsgemäße Bedienvorrichtung 610 mit einer Bedieneinheit 616 dargestellt an einer Glaskeramikplatte 612 oder einer beliebigen Blende. Der Drehregler 624 ist nach Art eines flachen Knopfes ausgebildet ähnlich Fig. 2. Dabei ist der Drehregler 624 an einer Regelgerätachse bzw. Drehachse 626 befestigt, die in einem Regelgerät 600 endet, das beispielsweise in der DE 198 33 983 A1 beschrieben ist. Die Drehachse 626 ragt durch einen entsprechenden Durchbruch in der Glaskeramikplatte 612. Durch Drehen an dem Drehregler 624 wird somit die Drehbewegung über die Drehachse 626 auf das Regelgerät 600 übertragen, beispielsweise ähnlich wie für die anderen Bedienvorrichtungen zur Leistungseinstellung an einem Elektrogerät bzw. Kochfeld.

Der Drehregler 624 weist ähnlich wie in den Ausführungen nach Fig. 2 verschiedene metallische bzw. flächige elektrisch leitfähige Berührsensoren 652 auf. Ein erster Berührsensor 652a ist links an der Oberseite des Drehreglers 624 in einer Mulde vorgesehen. Er weist eine elektrisch leitfähige Verbindung 650a zu der Drehachse 626 auf und geht dort in eine elektrisch leitfähige Umhüllung bzw. ein metallisches Rohr 651 a als Achse über, die außen an der Drehachse 626 angebracht ist. Sie kann allgemein auch ein ausreichend stabiles metallisches Rohr sein, das die eigentliche Achse bildet, und mit isolierendem Kunststoff gefüllt sein, in dem wiederum die elektrisch leitfähige Verbindung 650b verläuft. Kurz vor dem Übergang der Drehachse 626 in das Regelgerät 600 ist eine elektrisch getrennte ringförmige bzw. manschettenförmige Elektrode 673a vorgesehen, die die Drehachse 626 und auch das Rohr 651 a umgibt. Ein Berühren des Berührsensors 652a durch einen Benutzer wird über die zuvor bereits beschriebene elektrisch leitfähige Verbindung 650a und das Rohr 651 a entlang der Drehachse 626 hinter die Glaskeramikplatte 612 übertragen. Dort kann das Signal durch die Elektrode 673a erfasst werden für eine weitere Verarbeitung. Dadurch dass Umhüllung 651 a und die Elektrode 673a umlaufend ausgebildet sind, erfolgt die Übertragung in jeder Drehstellung, ähnlich wie es für die Fig. 7 zuvor beschrieben worden ist. In der rechten Mulde ist eine kleine Erhebung vorgesehen als taktile Erkennungshilfe für sehbehinderte Bedienpersonen.

Ein weiterer Berührsensor 652b ist in der Mitte der Oberseite des Drehreglers 624 vorgesehen. Seine elektrisch leitfähige Verbindung 650b verläuft zentral durch die Drehachse 626 zu einer unteren leitfähigen Fläche 651 b, welche an der Drehachse 626 befestigt ist. Dieser mit geringem Abstand zugeordnet ist eine feststehende Ringelektrode 673b, durch welche hindurch die Drehachse 626 verläuft. Ähnlich wie zuvor beschrieben kann somit eine Berührung des Berührsensors 652b an der Elektrode 673b abgegriffen bzw. erfasst werden für eine weitere Verwertung durch eine nicht dargestellte Steuerung.

Eine Art dritter Berührsensor 652c wird dadurch gebildet, dass an der Mantelseite des Drehreglers 624 eine einteilige, vorzugsweise ganz umlaufende elektrische Beschichtung oder elektrisch leitfähige Fläche aufgebracht ist. Diese ist flächig nach unten gezogen zur Unterseite des Drehreglers 624 als Elektrodenfläche 651c. Unterhalb der Glaskeramikplatte 612 ist eine große ringförmige Ringelektrode 673c vorgesehen, um eine Berührung des Berührsensors 652c über die Elektrodenfläche 651 c kapazitiv zu erfassen und an eine Steuerung zu übertragen. Die Elektrode 651 c und die Ringelektrode 673c sollten beide umlaufend bzw. möglichst vollflächig sein. Eine Ausbildungsform kann vorsehen, dass Berührsensor 652c und Elektrodenfläche 651 c eine Art Becher oder Topf bilden, der den Drehregler 624 seitlich nach außen und nach unten hin vollständig bzw. im wesentlichen vollständig bedeckt. In Erweiterung dieser Ausbildung ist es auch möglich, verschiedene voneinander getrennte Berührsensoren an dem streifenförmigen Außenrand des Drehreglers 624 vorzusehen. Diese Berührsensoren können dann zu Elektrodenflächen geführt sein, die mit unterschiedlichem radialen Abstand an der Unterseite des Drehreglers 624 vorgesehen sind. Sie bilden ähnlich der Fig. 6 und 7 Drehbahnen, allerdings mit unterschiedlichem Radius. Mittels Ringelektroden mit unterschiedlichem Radius unterhalb der Glaskeramikplatte 612 kann dann jeweils das Signal abgenommen werden.

Die Verbindung zwischen Drehregler 624 und Drehachse 626 kann einerseits fest sein, also unlösbar, was auch für die elektrischen Verbindungen gilt. Andererseits kann die Drehachse 626 in den Drehregler 624 eingesteckt werden. Dann sind entsprechende Kontaktmittel vorzusehen zwischen den elektrisch leitfähigen Verbindungen 650a und 650b sowie der Umhüllung 651 a und dem Abschnitt der Verbindung 650b innerhalb der Drehachse 626, also der Verbindung zur Fläche 651 b. Hier reichen in der Regel einfache Kontaktflächen, da der Kontakt nicht oft gelöst wird.

Ist nur einer der beiden Berührsensoren 652a und 652b vorgesehen, so kann alternativ die gesamte Drehachse 626 elektrisch leitfähig ausgebildet sein, beispielsweise aus Metall, und die Signalübertragung übernehmen. Dadurch ist ein einfacherer Aufbau möglich. Ebenso können anstelle der kapazitiven Signalabnahmen durch die Elektroden 673a und 673b auch elektrische Schleifer als Abnehmer vorgesehen sein, wobei dann auch diese letztendlich das kapazitive Signal der Berührung an einen der Berührsensoren übertragen.

In Fig. 9 ist eine weitere Abwandlung der Bedienvorrichtung dargestellt als Bedienvorrichtung 710 mit einer Bedieneinheit 716. Ein wesentlicher Unterschied ist hier, dass ein Drehregler 724 aus einem flacheren breiteren Unterteil 724a und einem aufgesetzten, weitaus schmaleren Oberteil 724b besteht. Im dargestellten Beispiel sind sowohl Unterteil 724a als auch Oberteil 724b elektrisch leitfähig bzw. bestehen aus Metall, sind aber elektrisch gegeneinander isoliert. Unterhalb einer Glaskeramikplatte 712 ist eine Ringelektrode 773a um die Drehachse 726 herum vorgesehen zur Abnahme der Signale nach Berührung des metallischen Unterteils 724a. Anstelle eines gesamten elektrisch leitfähigen Unterteils 724a kann auch eine Konstruktion gemäß Fig. 8 mit elektrisch leitfähigen Flächen vorgesehen sein.

Der Oberteil 724b ist über einen Isolationsbereich 780, beispielsweise aus Kunststoff, mit dem Unterteil 724a verbunden. Eine Schaltachse bzw. Drehachse 726 besteht aus Metall und reicht sowohl durch die Glaskeramikplatte 712 mit einer entsprechenden Bohrung als auch durch die Isolation 780 in den Oberteil 724b hinein. Sie ist mit dem Oberteil 724b mechanisch und elektrisch verbunden, insbesondere weil dieser auch aus Metall besteht. Das Abnehmen des Signals von der Drehachse 726 erfolgt über die Außenelektrode 773b. Die Drehachse 726 reicht mit ihrem unteren Ende in das Regelgerät 700, welches wie zuvor beschrieben aufgebaut sein kann. Auch das Oberteil 724b kann anstelle aus massivem Metall ähnlich Fig. 8 ausgebildet sein mit elektrisch leitfähigen Flächen als Berührsensoren und elektrisch leitfähigen Verbindungen an einem Kunststoffkörper.

Im Ausführungsbeispiel nach Fig. 9 bildet die gesamte Außenseite des Unterteils 724a einen ersten Berührsensor 752a. Das gesamte Oberteil 724b bildet einen zweiten Berührsensor 752b. Die Verbindung der Drehachse 726 mit dem Drehregler 724 bzw. zumindest dem Oberteil 724b kann durch klemmendes Aufstecken erfolgen. Ebenso kann ähnlich Figur 8 die Drehachse 726 auch aus Kunststoff bestehen mit einer metallischen bzw. elektrisch leitfähigen Einlage nach unten.

## Patentansprüche

1. Elektrogerät mit einer Bedienvorrichtung (10; 110; 210; 310 F.R; 410, 510, 610, 710), mit einer Bedieneinheit (16; 116; 216; 316; 416, 516, 616, 716), die einen Dreh- oder Schieberegler (24; 124; 224; 324; 424, 524, 624, 724) umfasst, wobei die Bedieneinheit an einer Blende bzw. Auflagefläche (12; 112; 212; 312, 612, 712) des Elektrogeräts gehaltert ist, wobei auf dem Dreh- oder Schieberegler (24; 124; 224; 324; 424, 524, 624, 724) mindestens ein weiteres Schaltmittel (38; 152, 230, 231; 452, 552, 652, 752) als Berührschalter bzw. Berührsensor vorgesehen ist mit einer Signalübertragung eines Schaltvorgangs an ein unter der Auflagefläche angeordnetes Steuergerät (57, 157), **gekennzeichnet durch** eine kapazitive Kopplung in dem weiteren Schaltmittel zur Signalübertragung mittels der kapazitiven Kopplung **durch** die Blende bzw. Auflagefläche an das Steuergerät .

2. Elektrogerät nach Anspruch 1, **dadurch gekennzeichnet, dass** das weitere Schaltmittel (230, 231) ein Druckknopf ist, wobei vorzugsweise der Druckknopf (230) zum Schließen eines elektrischen Kontakts (231) bei der Betätigung ausgebildet ist.

3. Elektrogerät nach einem der vorstehenden Ansprüche, **dadurch gekennzeichnet, dass** das weitere Schaltmittel (38, 152a-c, 452, 552, 652, 752) auf kapazitiver Basis mit einer Berührungsfläche (38, 152a-c, 452, 552, 652, 752) an dem Drehregler (24, 124, 424, 524, 624, 724) ausgebildet ist.

4. Elektrogerät nach einem der vorstehenden Ansprüche, **dadurch gekennzeichnet, dass** die Bedienvorrichtung (110) zur Registrierung der Drehstellung des Drehreglers (124) auf der Seite der Bedieneinheit (116) mit einem Magnetanker (130) verbunden ist, der vorzugsweise drehfest mit dem Drehregler (124) ausgebildet ist, und auf Seite des Auflagefläche (112) mit Magnetsensoren (142) zur Registrierung einer Bewegung des Magnetankers ausgebildet ist, wobei vorzugsweise durch Betätigung des weiteren Schaltmittels (152a-c) eine Distanz zwischen Magnetanker und Auflagefläche veränderbar ist.

5. Elektrogerät nach einem der vorstehenden Ansprüche, **dadurch gekennzeichnet, dass** die Bedieneinheit zur Signalübertragung eines Schaltvorgangs des weiteren Schaltmittels mittels einer Veränderung eines magnetischen Feldes unterhalb der Auflagefläche ausgebildet ist, wobei vorzugsweise diese Veränderung durch eine Lageveränderung einer Komponente der Bedieneinheit auslösbar ist, insbesondere durch eine Lageveränderung in Richtung auf die Auflagefläche zu.

6. Elektrogerät nach einem der vorstehenden Ansprüche, **dadurch gekennzeichnet, dass** die Bedieneinheit (16) zur Signalübertragung eines Schaltvorgangs des weiteren Schaltmittels (38) mittels einer Veränderung eines elektrischen Feldes unterhalb der Auflagefläche (12) ausgebildet ist, wobei vorzugsweise diese Veränderung durch eine Lageveränderung einer Komponente (38) der Bedieneinheit auslösbar ist, insbesondere durch eine Lageveränderung in Richtung auf die Auflagefläche zu.

7. Elektrogerät nach einem der vorstehenden Ansprüche, **dadurch gekennzeichnet, dass** die Bedieneinheit (116) zur Signalübertragung eines Schaltvorgangs des weiteren Schaltmittels (152) mittels einer Veränderung einer elektrischen Feldstärke unterhalb der Auflagefläche (112) ausgebildet ist, wobei diese Veränderung durch eine Berührung des weiteren Schaltmittels (152) durch einen Bediener auslösbar ist.

8. Elektrogerät nach einem der vorhergehenden Ansprüche, **dadurch gekennzeichnet, dass** die Bedieneinheit (16; 116; 216; 316; 416, 516) zur lösbaren Lagerung auf der Blende oder Auflagefläche (12; 112; 212; 312) des Elektrogeräts ausgebildet ist, vorzugsweise mittels einer magnetischen Haltekraft.

9. Elektrogerät nach einem der Ansprüche 1 bis 7, **dadurch gekennzeichnet, dass** die Bedieneinheit bzw. der Drehregler (624, 724) mittels einer ortsfesten drehbaren Achse (626, 726) gehaltert ist, die durch eine Blende oder Auflagefläche (612; 712) des Elektrogeräts verläuft, wobei vorzugsweise die Achse an einem Einstellgerät (600, 700) wie einem Potentiometer, Gray-Code-Schalter oder Energieregler sitzt.

10. Elektrogerät nach Anspruch 9, **gekennzeichnet durch** eine Signalübertragung mittels bzw. an der Achse (626, 726), vorzugsweise über einen elektrischen Leiter (650b, 651a, 726), wobei insbesondere an der Achse ein längs verlaufender Leiter (650b, 651a) bzw. Draht angeordnet ist.

11. Elektrogerät nach Anspruch 9 oder 10, **dadurch gekennzeichnet, dass** die Achse (726) am Drehregler (724) mit einem Schaltmittel (752b) im Drehregler verbunden ist, vorzugsweise mittels einer direkten elektrischen Verbindung.

12. Elektrogerät nach einem der Ansprüche 9 bis 11, **dadurch gekennzeichnet, dass** ein elektrischer Leiter (650b) an der Achse (626) an seinem unteren Ende mit einer Kondensatorplatte (651 b) verbunden ist, die eine kapazitive Kopplung zu einer Gegenkondensatorplatte (673b) aufbaut.

13. Elektrogerät nach einem der Ansprüche 9 bis 12, **dadurch gekennzeichnet, dass** ein elektrischer Leiter an der Achse (626, 726) in einem mittleren Bereich mit einer ersten Kondensatorfläche (651 a, 726) entlang des Achsumfangs verbunden ist, wobei die erste Kondensatorfläche (651a, 726) mit geringem Abstand von einer weiteren zweiten Kondensatorfläche (673a, 773b) umgeben ist.

14. Elektrogerät nach einem der Ansprüche 9 bis 13, **dadurch gekennzeichnet, dass** der Drehregler in die Blende bzw. Auflagefläche des Elektrogeräts hinein versenkbar ausgebildet ist, vorzugsweise mittels einer zweiteiligen Drehachse, die nach Art eines Teleskops ineinander schiebbar ausgebildet ist, wobei im eingeschobenen Zustand der Drehregler nicht über die Blende bzw. Auflagefläche übersteht.

15. Elektrogerät nach einem der vorhergehenden Ansprüche, **dadurch gekennzeichnet, dass** der Drehregler (724) mehrstufig mit unterschiedlichem bzw. abnehmendem Durchmesser ausgebildet ist, vorzugsweise mit einem ersten Knebel-Abschnitt mit großem Durchmesser als Unterteil (724a) und mit einem zweiten Knebel-Abschnitt darauf mit kleinem Durchmesser als Oberteil (724b), wobei insbesondere jeder Knebel-Abschnitt mit unterschiedlichen Schaltmitteln (752a, 752b) verbunden ist bzw. diese aufweist.

16. Elektrogerät nach einem der vorhergehenden Ansprüche, **dadurch gekennzeichnet, dass** die Erkennung der Drehposition des Drehreglers (424) kapazitiv erfolgt, vorzugsweise über mindestens ein kapazitives Element (472) im Drehknebel (424) und eine Vielzahl entsprechender kapazitiver Elemente (473) unter der Auflagefläche.

17. Elektrogerät nach Anspruch 16, **dadurch gekennzeichnet, dass** eines der kapazitiven Elemente (472a) im Drehknebel (424) mit einem Berührsensor (452a) und dass ein anderes kapazitives Element (472b) mit einem anderen Berührsensor (452b) und einem weiteren kapazitiven Element (418), vorzugsweise in einem Mittenbereich angeordnet, elektrisch verbunden ist.

18. Elektrogerät nach einem der Ansprüche 1 bis 15, **gekennzeichnet durch** eine optische Erkennung der Drehposition des Drehknebels (324), vorzugsweise über unterschiedliche Gestaltungen der Unterseite des Drehknebels mit unterschiedlichen optischen Eigenschaften (371, 372) und unter der Auflagefläche angeordneten optischen Sensoren, insbesondere Reflexlichtschranken (342a bis 342e).

19. Elektrogerät nach einem der vorhergehenden Ansprüche, **dadurch gekennzeichnet, dass** mindestens ein kapazitives Element (418, 518, 570, 651c, 752a) im Drehregler (424, 524, 624, 724) mit einem Berührsensor (452b, 552a, b; 652c, 752a) verbunden ist und derart ausgebildet ist, dass es unabhängig von einer Drehposition
immer über mindestens einem entsprechenden kapazitiven Element (420, 520, 571, 673c, 773a) unter der Auflagefläche (612, 712) steht.

20. Elektrogerät nach einem der vorhergehenden Ansprüche, **dadurch gekennzeichnet, dass** der Drehregler beleuchtbar ist bzw. Leuchtmittel aufweist, vorzugsweise im Bereich der Schaltmittel, wobei insbesondere die Leuchtmittel LED sind und vorzugsweise eine Energieversorgung durch kontaktlose Energieübertragung erfolgt, vorzugsweise induktiv.

21. Bedienverfahren zur Bedienung eines Elektrogerätes, insbesondere eines Kochfeldes, nach einem der vorstehenden Ansprüche, **dadurch gekennzeichnet, dass** durch Betätigen des weiteren Schaltmittels (38; 152, 230, 231; 452, 552) eine Einstellung durch Bewegen des Drehreglers (24, 124, 224, 324, 424, 524) mit einer anderen Funktion hervorgerufen wird als bei unbetätigtem weiteren Schaltmittel.

22. Bedienverfahren nach Anspruch 21, **dadurch gekennzeichnet, dass** in zumindest einem speziellen Betriebsmodus das weitere Schaltmittel (152, 452, 552) betätigt wird und betätigt gehalten wird und gleichzeitig der Drehregler (124, 424, 524) betätigt bzw. bewegt wird zur Bedienung.

23. Bedienverfahren zur Bedienung eines Elektrogerätes, insbesondere eines Kochfeldes, nach einem der Ansprüche 1 bis 20, **dadurch gekennzeichnet, dass** das Betätigen des weiteren Schaltmittels (38; 152, 230, 231; 452, 552) eine einzelne Schaltfunktion auslöst, insbesondere den Start des Betriebs einer Funktionseinheit des Elektrogerätes nach zuvor durch Bewegen des Drehreglers (24, 124, 224, 324, 424, 524) eingestellter Maßgabe, vorzugsweise nach Einstellung einer Leistungshöhe.

24. Bedienverfahren nach einem der Ansprüche 21 bis 23, **dadurch gekennzeichnet, dass** durch Betätigen eines weiteren Schaltmittels (38; 152, 230, 231; 452, 552) eine gerade selektierte Funktion ausgewählt bzw. bestätigt werden kann.

25. Bedienverfahren nach Anspruch 23 oder 24 im Rückbezug auf 23, **dadurch gekennzeichnet, dass** durch Bewegen des Drehknebels (324, 424) in eine bestimmte Drehposition, insbesondere auf eine unter der Auflagefläche angebrachte Anzeige einer Kochstelle, eine bestimmte Funktion bzw. diese Kochstelle selektiert ist und entweder nach entsprechender Bestätigung durch ein Schaltmittel oder durch Ändern des Betriebsmodus durch ein entsprechendes Schaltmittel eine weitere Funktion einstellbar ist, insbesondere eine Einstellung der Leistungshöhe oder Timer-Funktion für diese selektierte Kochstelle.

## Claims

1. An electrical appliance including an operating device (10; 110; 210; 310; 410, 510, 610, 710) with an operating unit (16; 116; 216; 316; 416, 516, 616, 716) comprising a rotary or a sliding control (24; 124; 224; 324; 424, 524, 624, 724), said operating unit being supported on a panel and/or area of support (12; 112; 212; 312; 612, 712) of the electrical appliance, wherein on said rotary or sliding control (24; 124; 224; 324; 424, 524, 624, 724) is provided at least one further switching means (38; 152, 230, 231; 452, 552, 652, 752) as a contact switch and/or a contact sensor with a signal transmission of a switching process to said control unit (57, 157) arranged beneath the area of support, **characterized in that** a capacitive coupling is provided in the further switching means for signal transmission by means of the capacitive coupling through said panel and/or area of support to the control unit.

2. The electrical appliance according to claim 1, **characterized in that** said further switching means (230, 231) is a pushbutton, wherein preferably the pushbutton (230) is configured to close an electrical contact (231) upon operation.

3. The electrical appliance according to any of the preceding claims, **characterized in that** said further switching means (38, 152a-c, 452, 552, 652, 752) is a capacitively based contact switch having a contact surface (38, 152a-c, 452, 552, 652, 752) and provided on said rotary control (24, 124, 424, 524,624,724).

4. The electrical appliance according to any of the preceding claims, **characterized in that** said operating device (110) is connected on the side of the operating unit (116) to a magnetic armature (130) for recording said rotary position of said rotary control (124), preferably said magnetic armature being rotatably fixed to the rotary control (124), and on the side of the area of support (112) magnetic sensors (142) are provided for recording a movement of said magnetic armature, wherein preferably by actuation of the further switching means (152a-c) a distance between said magnetic armature and said area of support changes.

5. The electrical appliance according to any of the preceding claims, **characterized in that** said operating unit is constructed for signal transmission of a switching process of said further switching means by means of a change to a magnetic field below said area of support, wherein preferably said change is initiated by a position change to a component of said operating unit, in particular by a position change in a direction towards the area of support.

6. The electrical appliance according to any of the preceding claims, **characterized in that** said operating unit (16) is constructed for signal transmission of a switching process of said further switching means (38) by means of a change to an electric field below said area of support (12), wherein preferably said change is initiated by a position change to a component (38) of said operating unit, in particular by a position change in a direction towards the area of support.

7. The electrical appliance according to any of the preceding claims, **characterized in that** said operating unit (116) is constructed for signal transmission of a switching process of said further switching means (152) by means of a change to an electric strength below said area of support (112), wherein said change is initiated by a human operator by contacting said further switching means (152).

8. The electrical appliance according to any of the preceding claims, **characterized in that** said operating unit (16; 116; 216; 316; 416, 516) is constructed for releasable mounting on said electrical appliance panel or area of support (12; 112; 212; 312), preferably by means of a magnetic force action.

9. The electrical appliance according to any of the claims 1 through 7, **characterized in that** said operating unit and/or rotary control (624, 724) is supported by means of a fixed, rotary shaft (626, 726) which runs through a panel or area of support (612; 712) of the electrical appliance, wherein preferably said shaft is located on a setting device (600, 700), like a potentiometer, Gray-Code-Switch or power control.

10. The electrical appliance according claim 9, **characterized in that** signal transmission takes place by means and/or on the shaft (626, 726), preferably by an electric conductor (650b, 651 a, 726), wherein in particular an electric conductor (650b, 651 a) and/or wire directed longitudinally along said shaft is provided.

11. The electrical appliance according to claim 9 or 10, **characterized in that** said shaft (726) on the rotary control (724) is connected to a switching means (752b) in the rotary control, preferably by means of a direct electrical connection.

12. The electrical appliance according to any of claims 9 through 11, **characterized in that** an electric conductor (650b) on said shaft (626) is connected to a capacitor plate (651 b) at the lower end, wherein said capacitor plate builds up a capacitive coupling with a counter-capacitor plate (673b).

13. The electrical appliance according to any of claims 9 through 12, **characterized in that** an electric conductor on said shaft (626, 726) is connected to a first capacitor face (651 a, 726) in a central area along an axial circumference, wherein said first capacitor face (651 a, 726) is surrounded with a limited spacing by a further, second capacitor face (673a, 773b).

14. The electrical appliance according to any of claims 9 through 13, **characterized in that** said rotary control is constructed to be plunged in the panel and/or area of support of the electrical appliance, preferably by means of a two-part pivot shaft, which can be engaged in one another in the manner of a telescope, wherein in the inserted state the rotary control does not project over the panel and/or area of support.

15. The electrical appliance according to any of the preceding claims, **characterized in that** said rotary control (724) is constructed in multistage manner with a different and/or decreasing diameter, preferably with a first large diameter toggle portion as lower part (724a) and a second, large diameter toggle portion as upper part (724b), wherein in particular each toggle portion is connected to and/or includes different switching means (752a, 752b).

16. The electrical appliance according to any of the preceding claims, **characterized in that** there is a capacitive detection of said rotary position of said rotary control (424), preferably by means of at least one capacitive element (472) in said rotary toggle (424) and a plurality of corresponding capacitive elements (473) beneath said area of support.

17. The electrical appliance according to claim 16, **characterized in that** one of the capacitive elements (472a) in said rotary toggle (424) is electrically connected to a contact sensor (452a) and wherein another capacitive element (472b) is electrically connected to another contact sensor (452b) and to another capacitive element (418), preferably located in a central area.

18. The electrical appliance according to any of claims 1 through 15, **characterized in that** detection of a rotary position of the rotary toggle (324) can take place optically, preferably by differently designed undersides of the rotary toggle and different optical characteristics (371, 372) and optical sensors arranged beneath the said area of support, in particular reflected light barriers (342a through 342e).

19. The electrical appliance according to any of the preceding claims, **characterized in that** at least one capacitive element (418, 518, 570, 651 c, 752a) in the rotary control (424, 524, 624, 724) is connected to a contact sensor (452b, 552a, b; 652c, 752a) and is constructed in such a way that, independently of said rotary position, said capacitive element projects over at least one corresponding capacitive element (420, 520, 571, 673c, 773a) beneath said area of support (612, 712).

20. The electrical appliance according to any of the preceding claims, **characterized in that** said rotary control can be illuminated and/or have lighting means, preferably in the vicinity of the switching means, wherein in particular the lighting means can be LED, and preferably a power supply is provided by contactless power transmission, preferably inductively.

21. A method for operating an electrical appliance, in particular a cooking field, according to any of the preceding claims, **characterized in that** by operating said further switching means (38; 152, 230, 231; 452, 552) a setting by moving said rotary control (24, 124, 224, 324, 424, 524) effects a different function as compared to when said switching means is deactivated.

22. The method according to claim 21, **characterized in that** at least in a special operating mode said further switching means (152, 452, 552) is activated and is being kept in said activated state, and wherein at the same time said rotary control (124, 424, 524) is activated and/or moved for operation.

23. The method for operating an electrical appliance, in particular a cooking field, according to any of the claims 1 through 20, **characterized in that** activating said further switching means (38; 152, 230, 231; 452, 552) effects a single switching function, in particular starting the operation of a functional unit of said appliance in accordance with instructions given by moving said rotary control (24, 124, 224, 324, 424, 524), preferably after setting of a power level.

24. The method according to any of the claims 21 through 23, **characterized in that** by activating said further switching means (38; 152, 230, 231; 452, 552) a presently selected function of said operating device is chosen and/or effected.

25. The method according to claim 23 or 24, when dependent from claim 23, **characterized in that** by moving said rotary toggle (324, 424) into a specific position, in particular to a display of a cooking field arranged beneath the area of support, a certain function and/or said cooking field is being selected and, after either actuation by said switching means or changing said operating mode by a switching means, a further function of said electrical appliance is being set, in particular said setting is related to a power level or a timer function for said selected cooking field.

## Revendications

1. Appareil électrique équipé d'un dispositif de commande (10 ; 110 ; 210 ; 310 ; 410, 510, 610, 710), doté d'une unité de commande (16 ; 116 ; 216 ; 316 ; 416, 516, 616, 716) comprenant un élément de réglage par rotation ou coulissement (24 ; 124 ; 224 ; 324 ; 424, 524, 624, 724), l'unité de commande étant maintenue contre un écran et/ou une surface d'appui (12 ; 112 ; 212 ; 312, 612, 712) de l'appareil électrique, au moins un moyen de connexion (38 ; 152, 230, 231 ; 452, 552, 652, 752) supplémentaire prenant la forme d'un contacteur par effleurement et/ou d'un capteur d'effleurement étant prévu sur l'élément de réglage par rotation ou coulissement (24 ; 124 ; 224 ; 324 ; 424, 524, 624, 724), avec une transmission de signal d'une activité de connexion à un appareil de commande (57, 157) disposé sous la surface d'appui, **caractérisé par** la présence d'un couplage capacitif dans le moyen de connexion supplémentaire pour la transmission de signal à l'aide du couplage capacitif à travers l'écran et/ou la surface d'appui placée contre l'appareil de commande.

2. Appareil électrique selon la revendication 1, **caractérisé en ce que** le moyen de connexion supplémentaire (230, 231) est un bouton-poussoir, le bouton-poussoir (230) étant de préférence réalisé pour fermer un contact électrique (231) par son actionnement.

3. Appareil électrique selon l'une quelconque des revendications précédentes, **caractérisé en ce que** le moyen de connexion supplémentaire (38, 152a-c, 452, 552, 652, 752) est réalisé sur une base capacitive avec une surface d'effleurement (38,152a-c, 452, 552, 652, 752) prévue contre l'élément de réglage par rotation (24, 124, 424, 524, 624, 724).

4. Appareil électrique selon l'une quelconque des revendications précédentes, **caractérisé en ce que** le dispositif de commande (110) est relié à une ancre magnétique (130) pour l'enregistrement de la position de rotation de l'élément de réglage par rotation (124) sur le côté de l'unité de commande (116), ladite ancre étant de préférence réalisée solidairement en rotation avec l'élément de réglage par rotation (124) et étant réalisée sur le côté de la surface d'appui (112) doté de capteurs magnétiques (142) en vue d'enregistrer un mouvement de l'ancre magnétique, une distance entre l'ancre magnétique et la surface d'appui pouvant de préférence être modifiée par actionnement du moyen de connexion (152a-c) supplémentaire.

5. Appareil électrique selon l'une quelconque des revendications précédentes, **caractérisé en ce que** l'unité de commande est réalisée pour la transmission de signal d'une activité de connexion du moyen de connexion supplémentaire à l'aide d'une modification d'un champ magnétique placé sous la surface d'appui, cette modification pouvant de préférence être déclenchée par un changement de position d'un composant de l'unité de commande, notamment par le biais d'un changement de position en direction de la surface d'appui.

6. Appareil électrique selon l'une quelconque des revendications précédentes, **caractérisé en ce que** l'unité de commande (16) est réalisée pour la transmission de signal d'une activité de connexion du moyen de connexion (38) supplémentaire par le biais d'une modification d'un champ électrique placé sous la surface d'appui (12), cette modification pouvant de préférence être déclenchée par un changement de position d'un composant (38) de l'unité de commande, notamment par un changement de position en direction de la surface d'appui.

7. Appareil électrique selon l'une quelconque des revendications précédentes, **caractérisé en ce que** l'unité de commande (116) est réalisée pour la transmission de signal d'une activité de connexion du moyen de connexion (152) supplémentaire par le biais d'une modification de la force d'un champ électrique placé sous la surface d'appui (112), cette modification pouvant être déclenchée par un effleurement du moyen de connexion (152) supplémentaire par un utilisateur.

8. Appareil électrique selon l'une quelconque des revendications précédentes, **caractérisé en ce que** l'unité de commande (16 ; 116 ; 216 ; 316 ; 416, 516) est réalisée pour être positionnée de façon amovible sur l'écran ou la surface d'appui (12 ; 112 ; 212 ; 312) de l'appareil électrique, de préférence au moyen d'une force de retenue magnétique.

9. Appareil électrique selon l'une quelconque des revendications 1 à 7, **caractérisé en ce que** l'unité de commande et/ou l'élément de réglage par rotation (624, 724) est maintenu à l'aide d'un axe (626, 726) pouvant tourner fixement sur place et traversant un écran ou une surface d'appui (612 ; 712) de l'appareil électrique, l'axe reposant de préférence contre un appareil de réglage (600, 700) tel un potentiomètre, un contacteur de type à code de Gray ou un élément de réglage de puissance.

10. Appareil électrique selon la revendication 9, **caractérisé par** la présence d'une transmission de signal à l'aide et/ou contre l'axe (626, 726), de préférence par le biais d'un conducteur électrique (650b, 651a, 726), un conducteur (650b, 651a) et/ou un fil s'étendant dans le plan longitudinal étant notamment disposé contre l'axe.

11. Appareil électrique selon la revendication 9 ou 10, **caractérisé en ce que** l'axe (726) placé contre l'élément de réglage par rotation (724) est relié à un moyen de connexion (752b) prévu dans l'élément de réglage par rotation, de préférence par le biais d'une liaison électrique directe.

12. Appareil électrique selon l'une quelconque des revendications 9 à 11, **caractérisé en ce qu'**un conducteur électrique (650b) est relié à une plaque de condensateur (651b) au niveau de l'axe (626), au niveau de son extrémité inférieure, ladite plaque établissant un couplage capacitif avec une contreplaque de condensateur (673b).

13. Appareil électrique selon l'une quelconque des revendications 9 à 12, **caractérisé en ce qu'**un conducteur électrique est relié à une première surface de condensateur (651a, 726) le long de la périphérie de l'axe, au niveau de l'axe (626, 726), dans une région centrale, la première surface de condensateur (651a, 726) étant entourée à faible distance par une deuxième surface de condensateur (673a, 773b) supplémentaire.

14. Appareil électrique selon l'une quelconque des revendications 9 à 13, **caractérisé en ce que** l'élément de réglage par rotation peut être abaissé dans l'écran et/ou la surface d'appui de l'appareil électrique, de préférence à l'aide d'un axe de rotation en deux parties réalisées de façon à pouvoir coulisser l'une dans l'autre à la façon d'un télescope, l'élément de réglage par rotation ne ressortant pas de l'écran et/ou de la surface d'appui à l'état rentré.

15. Appareil électrique selon l'une quelconque des revendications précédentes, **caractérisé en ce que** l'élément de réglage par rotation (724) est réalisé à plusieurs niveaux avec différents diamètres et/ou des diamètres décroissants, de préférence avec une première section de manette de grand diamètre servant de partie inférieure (724a) et une deuxième section de manette de plus petit diamètre placée dessus prenant la forme de la partie supérieure (724b), chaque section de manette étant notamment reliée aux différents moyens de connexion (752a, 752b) et/ou étant dotée de ces moyens.

16. Appareil électrique selon l'une quelconque des revendications précédentes, **caractérisé en ce que** la détection de la position de rotation de l'élément de réglage par rotation (424) est réalisée de façon capacitive, de préférence par le biais d'au moins un élément capacitif (472) prévu dans la manette de rotation (424) et d'une pluralité d'éléments capacitifs (473) correspondants prévus sous la surface d'appui.

17. Appareil électrique selon la revendication 16, **caractérisé en ce qu'**un des éléments capacitifs (472a) prévu dans la manette de rotation (424) est relié sur le plan électrique à un capteur d'effleurement (452a) et qu'un autre élément capacitif (472b) est relié sur le plan électrique à un autre capteur d'effleurement (452b) et à un élément capacitif (418) supplémentaire, disposé de préférence dans une région centrale.

18. Appareil électrique selon l'une quelconque des revendications 1 à 15, **caractérisé par** la présence d'une détection optique de la position de rotation de la manette de rotation (324), de préférence par le biais de différentes configurations du côté inférieur de la manette de rotation avec différentes propriétés optiques (371, 372) et de capteurs optiques disposés sous la surface d'appui, notamment de barrières de lumière réfléchissante (342a à 342e).

19. Appareil électrique selon l'une quelconque des revendications précédentes, **caractérisé en ce qu'**au moins un élément capacitif (418, 518, 570, 651c, 752a) prévu dans l'élément de réglage par rotation (424, 524, 624, 724) est relié à un capteur d'effleurement (452b, 552a, b ; 652c, 752a) et réalisé de telle sorte qu'il se place toujours au-dessus d'au moins un élément capacitif (420, 520, 571, 673c, 773a) correspondant sous la surface d'appui (612, 712), indépendamment d'une position de rotation.

20. Appareil électrique selon l'une quelconque des revendications précédentes, **caractérisé en ce que** l'élément de réglage par rotation est éclairable et/ou comporte des moyens d'éclairage, de préférence dans la région des moyens de connexion, les moyens d'éclairage étant notamment des DEL et offrant de préférence une alimentation en énergie par transmission d'énergie sans contact, de préférence de façon inductive.

21. Procédé de commande permettant de commander un appareil électrique, notamment un plan de cuisson, selon l'une quelconque des revendications précédentes, **caractérisé en ce que** l'actionnement du moyen de connexion (38 ; 152, 230, 231 ; 452, 552) supplémentaire permet d'activer un réglage par déplacement de l'élément de réglage par rotation (24, 124, 224, 324, 424, 524) avec une autre fonction que lorsque le moyen de connexion supplémentaire n'est pas activé.

22. Procédé de commande selon la revendication 21, **caractérisé en ce que** le moyen de connexion (152, 452, 552) supplémentaire est actionné et maintenu actionné dans au moins un mode de fonctionnement spécifique et que l'élément de réglage par rotation (124, 424, 524) est simultanément actionné et/ou déplacé pour réaliser une commande.

23. Procédé de commande permettant de commander un appareil électrique, notamment un plan de cuisson, selon l'une quelconque des revendications 1 à 20, **caractérisé en ce que** l'actionnement du moyen de connexion (38 ; 152, 230, 231 ; 452, 552) supplémentaire déclenche une fonction de connexion individuelle, notamment le début du fonctionnement d'une unité fonctionnelle de l'appareil électrique au prorata, réglé au préalable par déplacement de l'élément de réglage par rotation (24, 124, 224, 324, 424, 524), de préférence par réglage d'un niveau de puissance.

24. Procédé de commande selon l'une quelconque des revendications 21 à 23, **caractérisé en ce que** l'actionnement d'un moyen de connexion (38 ; 152, 230, 231 ; 452, 552) supplémentaire permet de sélectionner et/ou d'actionner une fonction venant d'être sélectionnée.

25. Procédé de commande selon la revendication 23 ou 24 en référence à la revendication 23, **caractérisé en ce que** le déplacement de la manette de rotation (324, 424) dans une position de rotation définie, notamment sur un affichage d'un point de cuisson placé sous la surface d'appui permet de sélectionner une fonction déterminée et/ou ce point de cuisson et que soit l'actionnement correspondant par un moyen de connexion soit la modification du mode de fonctionnement par un moyen de connexion correspondant permettent de régler une fonction supplémentaire, notamment un réglage du niveau de puissance ou de la fonction de minuterie de ce point de cuisson sélectionné.
